# EUROPÄISCHE PATENTSCHRIFT

(11) **EP 1 035 903 B1**
(45) Veröffentlichungstag und Bekanntmachung des Hinweises auf die Patenterteilung: **28.08.2002**
(21) Anmeldenummer: 98966170.7
(22) Anmeldetag: 26.11.1998
(51) Int. Cl.: B01D 45/08, F25B 43/00

(54) **FILTEREINRICHTUNG**
FILTERING DEVICE
INSTALLATION DE FILTRAGE

(30) Priorität: 27.11.1997 DE 19752669; 27.10.1998 DE 29819159 U
(43) Veröffentlichungstag der Anmeldung: 20.09.2000
(73) Patentinhaber: SIEMENS AKTIENGESELLSCHAFT, 80333 München (DE); Schaltgerätewerk Werder GmbH, 14542 Werder (DE)
(72) Erfinder: SPANIER, Horst, D-90482 Nürnberg (DE); MÜLLER, Frank, D-91056 Erlangen (DE); HAHN, Wolfgang, D-14542 Werder (DE)
(74) Vertreter: Berg, Peter
(86) Internationale Anmeldenummer: DE9803489
(87) Internationale Veröffentlichungsnummer: WO99028011

(56) Entgegenhaltungen:
- FR-A- 2 120 471
- GB-A- 2 136 312
- DATABASE WPI Section Ch, Week 8551 Derwent Publications Ltd., London, GB; Class J01, AN 85-319695 XP002102619 & JP 60 222121 A (MATSUSHITA SEIKO KK) , 6. November 1985

## Beschreibung

Die Erfindung betrifft eine Filtereinrichtung mit wenigstens einem von einem gasförmigen Kühlmedium durchströmbaren Ansaugfilter

Derartige Filtereinrichtungen dienen zur Reinigung des angesaugten bzw. des einströmenden gasförmigen Kühlmediums. Bei dem gasförmigen Kühlmedium handelt es sich im allgemeinen um Kühlluft, die zur Kühlung von elektrischen Geräten, wie z. B. Fahrmotoren von Schienenfahrzeugen, dient. Die Reinigung des gasförmigen Kühlmediums erfolgt durch Ansaugfilter. Bei mehrstufigen Filtereinrichtungen ist z. B. der Ansaugfilter der ersten Filterstufe als Grobstaubfilter und der Ansaugfilter der zweiten Filterstufe als Feinstaubfilter ausgebildet. Grobstaubfilter sind beispielsweise aus dem DE-GM 90 03 812 und aus der DD-PS 214 297 bekannt. Der Einsatz derartiger Grobstaubfilter in Schienenfahrzeugen ist z. B. in dem Aufsatz "Neuartige mechanische Abscheidegitter für die Kühlluft-Ansaugung" in ZEV-DET Glas. Ann. 115 (1991) Nr. 11/12, Seiten 333 bis 338, beschrieben.

Bei extremen Witterungsverhältnissen im Winter bzw. beim Einsatz in Kältegebieten kann es zur Vereisung bzw. zum Verschluß des Grobstaubfilters infolge Schneefall oder Eisregen kommen. Dies kann sowohl bei Filtereinrichtungen im Unterflurbereich (Triebwagen), bei Filteranlagen im Dachbereich (Lokomotiven, Straßenbahnen) und in der Seitenwand (Reisezugwagen) eintreten. Eine Vereisung bzw. ein Verschluß führt dazu, daß durch das Grobstaubfilter keine Kühlluft mehr durchströmen kann.

Bei mechanischen Abscheidegittern für die Kühlluft-Ansaugung, die als Grobstaubfilter dienen und die z. B. als FSA-Gitter (Fliehkraft-Sedimentations-Abscheide-Gitter) oder als Mehrfachdüsen-Lüftungsgitter ausgebildet sind, ist es deshalb bekannt, daß eine elektrische Beheizung im Einströmprofil vorgesehen werden kann. Durch das damit mögliche Vorheizen der Abscheidegitter können negative Einflüsse durch Kälte vermieden werden.

Aufgabe der vorliegenden Erfindung ist es, eine Filtereinrichtung zu schaffen, welche als in sich geschlossenes, unabhängiges System, Ausfälle von Ansaugfiltern infolge von starken Schneefällen bzw. Vereisungen verhindert.

Die Aufgabe wird erfindungsgemäß durch die Merkmale im Anspruch 1 gelöst. Vorteilhafte Ausgestaltungen und Weiterbildungen der Erfindung sind in den weiteren Ansprüchen beschrieben.

Die Filtereinrichtung nach Anspruch 1 stellt ein in sich geschlossenes, unabhängiges System dar, das Ausfälle von Ansaugfiltern infolge von starken Schneefällen oder infolge von Vereisungen wirkungsvoll und zuverlässig verhindert. Die Heizvorrichtung umfaßt wenigstens ein Heizelement, das zumindest teilweise innerhalb wenigstens eines Einströmprofils angeordnet ist, wobei das Heizelement vorzugsweise als mehrfach U-förmig gebogener Heizstab mit einem vorzugsweise kreisförmigen Querschnitt ausgebildet sein kann.

Ein besonders effizientes Abtauen von Eis und Schnee kann erzielt werden, wenn die Einströmprofile und/oder Abscheideprofile als Hohlkörper ausgeführt sind, deren Querschnitte sich in Strömungsrichtung verjüngen, wobei die sich verjüngenden Abschnitte ebenfalls als Hohlprofile ausgeführt sind. Das Heizelement ist dabei in und/oder an dem sich verjüngenden Abschnitt wenigstens eines der Hohlprofilabschnitte angeordnet. Es kann bei dieser Variante mit den Wandungen des sich verjüngenden Hohlprofilabschnittes verklebt oder durch Formschluß darin gehalten sein. Besonders vorteilhaft ist eine Ausführungsform, bei der das Heizelement aus ein oder mehreren, von einem Trägermaterial umgebenden Heizdrähten besteht. Das Trägermaterial kann mit Vorteil so ausgebildet sein, daß es formschlüssig an die Außen- bzw. Innenkontur der Profile angepaßt ist. Als Trägermaterial kann vorteilhafterweise ein in die Hohlkammer einbringbarer Isolierstab oder eine in die Hohlkammer einbringbare Schüttung aus Isoliermaterial vorgesehen sein. Bei einer Anordnung, bei der das Ansaugfilter mehrere voneinander beabstandete Einströmprofile und Abscheideprofile aufweist, von denen jeweils zwei benachbarte Einströmprofile jeweils einen Gitter-Eintrittsspalt für das gasförmige Medium bilden, und bei der die Abscheideprofile parallel zu den Einströmprofilen verlaufen und in Strömungsrichtung gesehen, hinter den Einströmprofilen angeordnet sind, ist es vorteilhaft, wenn Heizelemente sowohl bei zumindest einigen Einströmprofilen als auch bei zumindest einigen unmittelbar dahinter liegenden Abscheideprofilen vorhanden sind.

Falls eine Information über die Außentemperatur erforderlich sein sollte oder gewünscht werden sollte, dann kann diese entweder durch einen externen Temperatursensor oder durch einen in der Filtereinrichtung integrierten Temperatursensor zur Verfügung gestellt werden. Durch die Berücksichtigung der Außentemperatur wird sichergestellt, daß nur dann die Heizvorrichtung eingeschaltet wird, wenn der Strömungsausfall aufgrund extremer, temperaturbedingter Witterungsverhältnisse verursacht ist.

Wird die Strömungsbewegung des gasförmigen Kühlmediums in der Filtereinrichtung durch einen Lüfter erzeugt bzw. verstärkt, dann kann der Lüfter während des Heizvorganges abgeschaltet werden, falls dies aus strömungs- und/oder klimatechnischen Gründen erforderlich sein sollte.

Es versteht sich in diesem Zusammenhang von selbst, daß die erfindungsgemäße Filtereinrichtung ein oder mehrere Grobstaubfilter und/oder ein oder mehrere Feinstaubfilter als Ansaugfilter aufweisen kann.

Gemäß einer weiteren Ausgestaltung der Erfindung kann sogar das Einströmprofil selbst als Heizelement ausgebildet sein. Bei dieser Variante wird das Abscheiden von Staub- und Schmutzpartikeln sowie Feuchtigkeitströpfchen in keiner Weise beeinträchtigt. Entsprechende sicherheitstechnische Anforderungen sind dabei selbstverständlich zu beachten.

In Abhängigkeit von der gewünschten Heizleistung muß nicht jedes Einströmprofil mit einem Heizelement ausgerüstet werden bzw. es muß nicht jedes Einströmprofil als Heizelement ausgebildet sein. Es ist vielmehr auch möglich, beispielsweise nur jedes zweite Einströmprofil mit einem Heizelement auszurüsten bzw. als Heizelement auszubilden. Auch eine beliebige Kombination der in den Ansprüchen beschriebenen Maßnahmen ist möglich, um eine vorgebbare Anzahl von Einströmprofilen zu beheizen.

Falls eine besonders hohe Heizleistung erforderlich ist, um z.B. ein Festfrieren des Tauwassers im Inneren des Ansaugfilters zu vermeiden, können, wie bereits angesprochen, auch Heizelemente in den in Strömungsrichtung hinter den Einströmprofilen angeordneten Abscheideprofilen angeordnet werden. Bei einer Integration von Heizelementen in den Abscheideprofilen ist darauf zu achten, daß diese in ihrer Abscheidefunktion nicht beeinträchtigt werden.

Für Filtereinrichtungen, die wenigstens ein Feinstaubfilter aufweisen, ist es vorteilhaft, mehrere Heizfäden vorzusehen, die im Inneren des Feinstaubfilters und/oder auf wenigstens einer der beiden Stirnflächen des Feinstaubfilters angeordnet sind. Die als Heizfäden ausgebildeten Elemente dienen hierbei gleichzeitig als mechanische Versteifung des Feinstaubfilters, das im allgemeinen aus einer Filtermatte aus Fliesmaterial besteht und deshalb auch als Mattenfilter bezeichnet wird.

Die Erfindung sowie weitere vorteilhafte Ausgestaltungen, die Gegenstand von weiteren Ansprüche sind, werden im folgenden an Hand von mehreren in der Zeichnung schematisch dargestellten Ausführungsbeispielen eines Ansaugfilters näher erläutert.
Es zeigen:
- FIG 1: Eine Vorderansicht eines Grobstaubfilters im Schnitt entlang der Linie I-I in FIG 2,
- FIG 2: eine Draufsicht auf den Grobstaubfilter gemäß FIG 1,
- FIG 3: einen Schnitt durch den Grobstaubfilter gemäß FIG 1 entlang der Linie III-III in FIG 1,
- FIG 4: einen Längsschnitt durch einen Feinstaubfilter,
- FIG 5 bis 11: verschiedene Varianten von Abscheideprofilen.

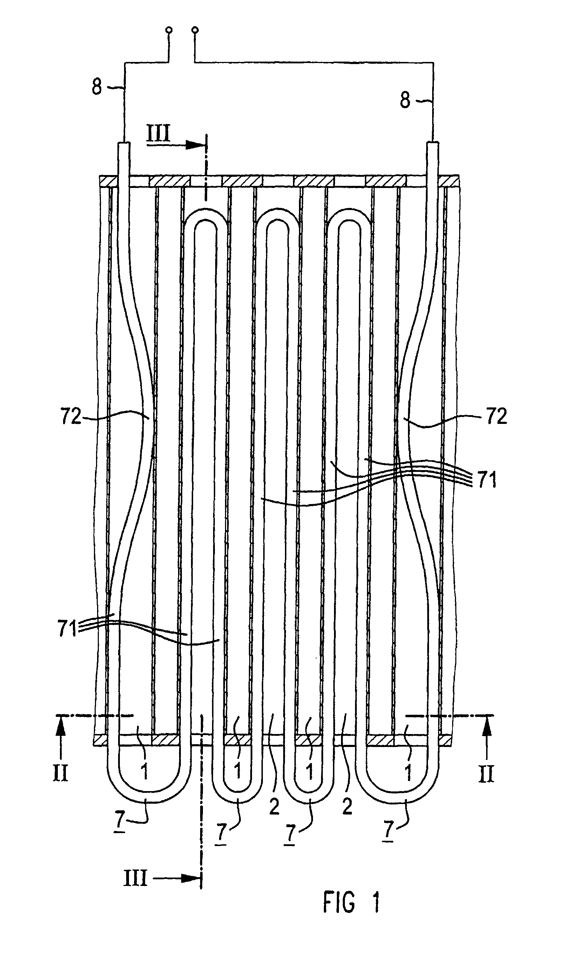

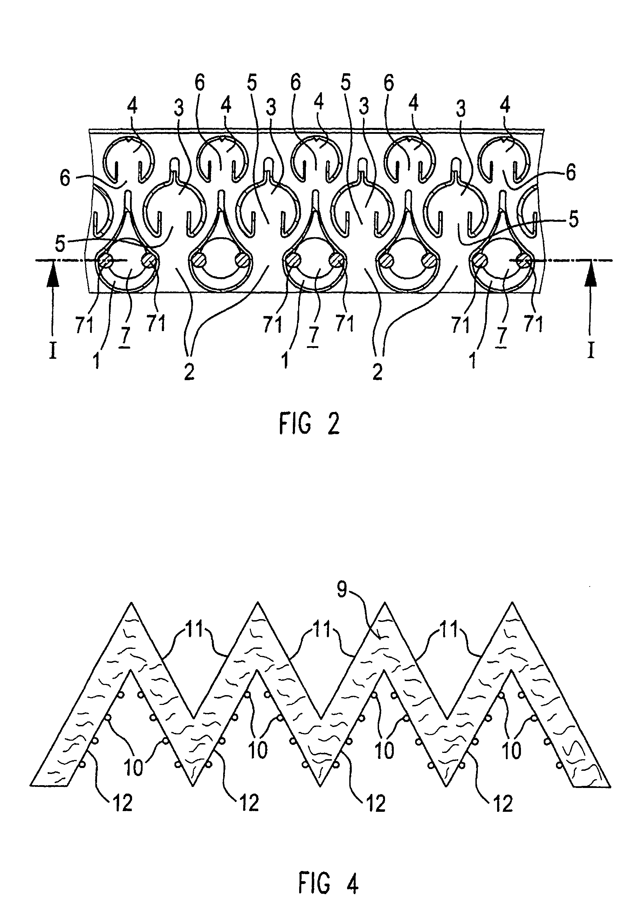

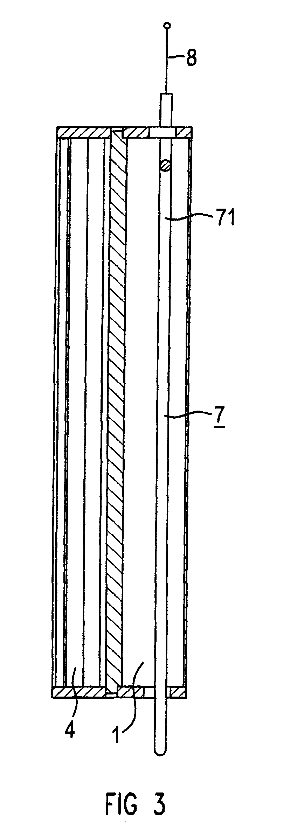

In den FIG 1 bis 3 sind mit 1 mehrere Einströmprofile eines Ansaugfilters bezeichnet, das als Grobstaubfilter (FSA-Gitter) ausgebildet ist. Die Einströmprofile sind voneinander beabstandet angeordnet, wobei zwei benachbarte Einströmprofile 1 jeweils einen Gitter-Eintrittsspalt 2 für ein gasförmiges Kühlmedium bilden, das den Ansaugfilter durchströmt (siehe FIG 1 und 2).

Die Einströmprofile 1 sind als Hohlprofile ausgebildet, deren Querschnitte sich in Strömungsrichtung des gasförmigen Kühlmediums verjüngen.

Weiterhin sind mehrere Abscheideprofile 3 und 4, in Strömungsrichtung gesehen, hinter den Einströmprofilen 1 angeordnet (siehe FIG 2). Die Abscheideprofile 3 und 4, die bei dem gezeigten FSA-Gitter ebenfalls als Hohlprofile ausgebildet sind, verlaufen parallel zu den Einströmprofilen 1. Die Abscheideprofile 3 und 4 weisen jeweils Eintrittsspalte 5 bzw. 6 auf, die dem einströmenden Kühlmedium zugewandt sind. Bei dem dargestellten Grobstaubfilter sind die Abscheideprofile 3 als Grobabscheideprofile und die Abscheideprofile 4 als Feinabscheideprofile ausgebildet. Die Grobabscheideprofile 3 sind, in Strömungsrichtung gesehen, hinter den Einströmprofilen 1 angeordnet, wobei die Eintrittsspalte 5 der Grobabscheideprofile 3 deckungsgleich zu den Gitter-Eintrittsspalten 2 verlaufen.

Die Feinabscheideprofile 4 sind, in Strömungsrichtung gesehen, hinter den Grobabscheideprofilen 3 angeordnet, wobei die Eintrittsspalte 6 dem einströmenden Kühlmedium zugewandt sind und hinter den Einströmprofilen 1 verlaufen.

Bei dem Ausführungsbeispiel gemäß den FIG 1 bis 3 gelangt das gasförmige Kühlmedium - im allgemeinen Luft, die mit Staub- und Schmutzpartikeln sowie Feuchtigkeitströpfchen behaftet ist - über die Gitter-Eintrittsspalte 2 in das Innere des Ansaugfilters. Die partikelbehaftete Kühlluft wird von den Eintrittsspalten 5 der Grobabscheideprofile 3 aufgestaut und scharf umgelenkt. Die Staub- und Schmutzpartikel gelangen infolge ihrer Trägheit über die Eintrittsspalte 5 in das Innere des jeweiligen Grobabscheideprofils 3 und bewegen sich aufgrund der Schwerkraft nach unten. Die Kühlluft wird in einem von den Einströmprofilen 1 und den Grobabscheideprofilen 3 gebildeten Strömungskanal zwangsgeführt. In Strömungsrichtung des gasförmigen Kühlmediums gesehen, erweitert sich der von den Einströmprofilen 1 und den Grobabscheideprofilen 3 gebildeten Strömungskanal.

Das gasförmige Kühlmedium gelangt dadurch in den Bereich der Feinabscheideprofile 4 und wird von den Eintrittsspalten 6 der Feinabscheideprofile 4 wiederum aufgestaut und nochmals umgelenkt. Noch vorhandene Staub- und Schmutzpartikel werden dadurch abgeschieden.

Das gasförmige Kühlmedium wird auf diese Weise zuverlässig gefiltert und kann damit bei Schienenfahrzeugen, z.B. für die Kühlung von Fahrmotoren, Traktionsumrichtern oder Hilfsbetrieben verwendet werden.

Um die Filtereinrichtung bei einem auftretenden kältebedingten Verschluß (Vereisung bzw. Verschluß des Ansaugfilters infolge von Schneefall oder Eisregen) wieder funktionstüchtig zu machen, ist erfindungsgemäß eine Heizvorrichtung vorgesehen, die bei dem in den FIG 1 bis 3 dargestellten Ausführungsbeispiel ein Heizelement 7 umfaßt, das als mehrfach U-förmig gebogener Heizstab ausgebildet ist.

Durch die mehrfachen U-förmigen Biegungen des Heizstabes 7 erhält man eine Vielzahl parallel verlaufender Stränge 71, die innerhalb der Einströmprofile 1 angeordnet sind (siehe FIG 1). Mit Ausnahme der beiden äußeren Stränge 71 sind jeweils zwei parallele Stränge 71 in einem Einströmprofil 1 angeordnet. Eine U-förmige Biegung des Heizstabes 7 liegt innerhalb des Einströmprofils 1. Die andere U-förmige Biegung liegt außerhalb des Einströmprofils 1 und bildet die Verbindung eines Stranges 71 im einen Einströmprofil mit einem Strang 71 im benachbarten Einströmprofil 1.

Die beiden äußeren Stränge 71 sind jeweils mit einer elektrischen Leitung 8 zur Spannungsversorgung verbunden. Die beiden äußeren Stränge 71 sind in einem innerhalb des Einströmprofils 1 liegenden Bereich 72 gekröpft. Durch den gekröpften Bereich 72 werden die beiden äußeren Stränge 71 in den betreffenden Einströmprofilen 1 mechanisch sicher fixiert, wodurch Schwingungen und temperaturabhängige Längenänderungen des Heizstabes 7 nicht zu einer verstärkten Geräuschbildung führen.

Als in den FIG 1 bis 3 nicht dargestellte Alternative zu den gekröpften Bereichen 72 können z. B. auch Federn als Fixierelemente vorgesehen werden. Die Federn stehen bei einem kalten Heizstab 7 unter einer definierten Vorspannung. Bei einer Erwärmung des Heizstabes 7 ergeben sich dann entsprechend reduzierte Federspannungen bei den Fixierelementen, wodurch die Stränge 71 des Heizstabes 7 jedoch ebenfalls sicher in den Einströmprofilen 1 fixiert werden.

In Abhängigkeit von der gewünschten Heizleistung muß nicht jedes Einströmprofil 1 mit einem Strang 71 des Heizstabes 7 ausgerüstet werden. Es ist vielmehr auch möglich, beispielsweise nur jedes zweite Einströmprofil 1 mit einem Strang 71 des Heizstabes 7 bzw. mit einem einzelnen Heizstab auszurüsten.

Gemäß einer weiteren Ausgestaltung ist es zusätzlich oder alternativ auch möglich, die Einströmprofile 1 selbst als Heizelemente auszubilden. Auch in diesem Fall kann der Ansaugfilter so ausgeführt sein, daß z. B. nur jedes zweite Einströmprofil 1 als Heizelement ausgeführt ist.

Falls eine besonders hohe Heizleistung erforderlich ist, um z.B. ein Festfrieren des Tauwassers im Inneren des Ansaugfilters zu vermeiden, ist es möglich, zusätzlich die Grobabscheideprofile 3 als Heizelemente auszubilden. Da im Inneren der Grobabscheideprofile 3 keine Heizelemente vorhanden sind, wird die Abscheidung von Staub- und Schmutzpartikeln sowie von Feuchtigkeitströpfchen nicht beeinträchtigt.

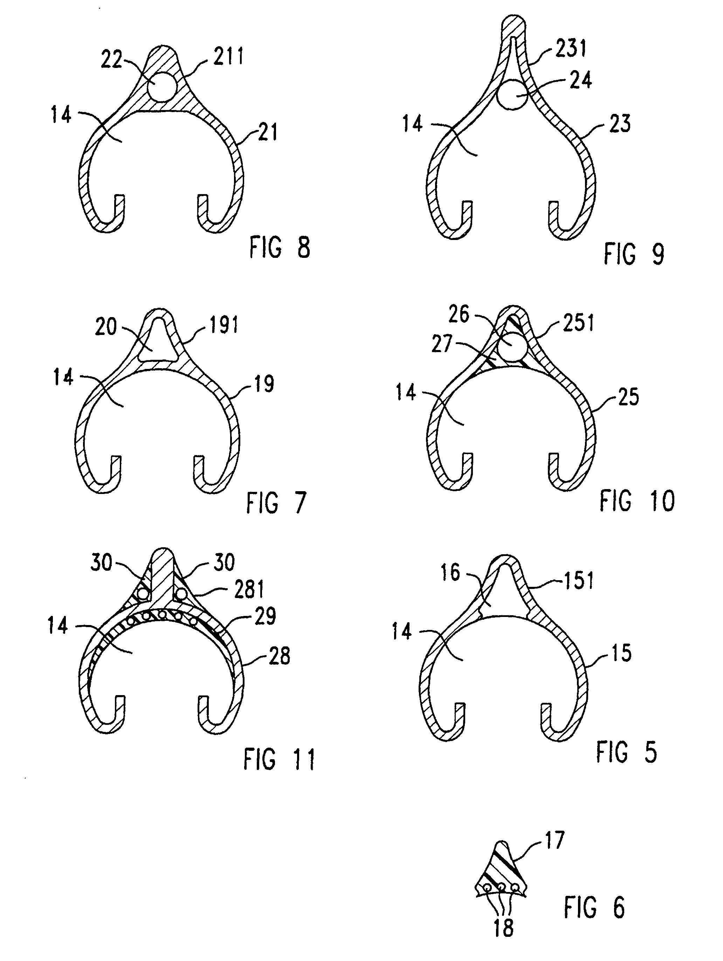

In FIG 4 ist ein Feinstaubfilter (Mattenfilter) dargestellt. Das Feinstaubfilter besteht aus einer Filtermatte 9 aus Fliesmaterial. Die Filtermatte ist derart ausgeformt, daß sich wellige Sirnflächen 11 und 12 ergeben. Durch die auf diese Weise vergrößerte Anströmfläche für das gasförmige Kühlmedium wird die Filterfläche vergrößert und damit die Standzeit des Feinstaubfilters erhöht. Im gezeigten Ausführungsbeispiel sind mehrere Heizfäden 10 an der Stirnseite 12 angeordnet, die dem gasförmigen Kühlmedium abgewandt ist. Alternativ oder zusätzlich können auch an der Stirnseite 11, die dem gasförmigen Kühlmedium zugewandt ist, Heizfäden 10 vorgesehen werden. Die Heizfäden 10 können bei allen erläuterten Ausgestaltungen sowohl parallel als auch gekreuzt angeordnet werden. Gemäß einer weiteren Variante ist es möglich, die Heizfäden 10 alternativ oder zusätzlich im Inneren der Filtermatte 9 anzuordnen. Bei einer Anordnung der Heizfäden 10 im Inneren der Filtermatte 9 ist eine beliebige Anordnung der Heizfäden realisierbar.

Die Figuren 5 bis 11 zeigen in einer Querschnittsdarstellung vorteilhafte Varianten einer Ausbildung der Abscheideprofile sowie Anordnung der Heizelemente in diesen Profilen. Analog dazu können auch die Einströmprofile ausgebildet sein; diese unterscheiden sich in Betrachtung der FIG 2 im wesentlichen nur dadurch, daß die Einströmprofile an der Vorderseite am Umfang geschlossen sind.

Gemeinsam diesen Varianten ist, daß die Abscheideprofile Hohlprofilkörper sind, welche einen mit 14 bezeichneten ersten Hohlraum enthalten der dazu dient, daß sich beim Durchströmen der Kühlluft Staub und Schmutzpartikel abscheiden können.

Die FIG 5 zeigt ein erstes Querschnittsprofil 15, bei dem in dem sich verjüngenden Abschnitt 151 der Hohlraum 14 sich in einen weiteren Hohlraum 16 fortsetzt. In diesen weiteren Hohlraum 16 wird ein in FIG 6 im Querschnitt dargestelltes Heizelement 17 eingelegt. Das Heizelement 17 kann ein oder mehrere einzelne Heizdrähte 18 enthalten. Die Querschnittsprofile von Heizelement 17 und Hohlraum 16 sind hier etwa dreieckförmig ausgeführt und in der Formgebung so gestaltet, daß das Heizelement 17 formschlüssig in dem Hohlraum 16 eingelegt und darin gehaltert werden kann.

Die FIG 7 zeigt ein Querschnittsprofil 19, in dessen sich verjüngendem Abschnitt 191 ein separater Hohlraum 20 vorgesehen ist, in den ein entsprechend ausgebildetes Heizelement eingelegt werden kann.

Die FIG 8 zeigt ein Querschnittsprofil 21, bei dem im sich verjüngendem Abschnitt 211 ein kreisförmiger Hohlraum 22 vorgesehen ist, in welchem ein entsprechend ausgebildetes Heizelement eingelegt werden kann. Das Heizelement kann auch hier mit Formschluß eingelegt werden. Als Trägermaterial für die einzelnen Heizdrähte eines Heizelements kann ein festes Isoliermaterial verwendet werden; denkbar und im Rahmen der Erfindung liegt es auch, als Trägermaterial loses Schüttgut zu verwenden, welches in die Hohlkammer eingebracht wird.

Die FIG 9 zeigt ein Querschnittsprofil 23, bei dem im sich verjüngenden Abschnitt 231 ein Heizelement in Form eines Heizstabes 24 angeordnet ist. Der Heizstab ist direkt an Wandungen des Hohlprofilkörpers befestigt. Die Befestigung kann beispielsweise durch Klebung erfolgen.

Die FIG 10 zeigt ein Querschnittsprofil 25, bei dem im sich verjüngenden Abschnitt 251 ein Heizelement in Form eines Heizstabes 26 angeordnet ist. Der Heizstab 26 ist hier in einem Trägermaterial 27 eingebettet, welches an den Innenwandungen des Profils 25 formschlüssig befestigt ist.

Die FIG 11 zeigt ein Querschnittsprofil 28, bei dem sowohl an den Innenwandungen als auch an den Außenwandungen des Profils ein Heizelement 29, 30 angeordnet ist. Auch hier sind die nicht näher bezeichneten Heizdrähte in einem besonderen Trägermaterial eingebettet welches mit den Profil formschlüssig verbunden ist.

Besondere Vorteile der aufgezeigten Ausbildung und Anordnung der Abscheideprofile in Verbindung mit entsprechend ausgebildeten Einströmprofilen werden dann erreicht, wenn im Einströmbereich sowohl zumindest einige der Einströmprofile als auch einige der dahinterliegenden Abscheideprofile mit derartigen Heizelementen versehen sind.

## Patentansprüche

1. Filtereinrichtung, die folgende Merkmale umfaßt:
- Wenigstens ein Ansaugfilter, das von einem gasförmigen Kühlmedium durchströmbar ist, das Ansaugfilter weist mehrere voneinander beabstandete Einströmprofile (1) und Abscheideprofile (3, 4) auf, wobei zwei benachbarte Einströmprofile (1) jeweils einen Gitter-Eintrittsspalt (2) für das gasförmige Medium bilden und die Abscheideprofile (3,4) parallel zu den Einströmprofilen (1) verlaufen und in Strömungsrichtung gesehen, hinter den Einströmprofilen (1) angeordnet sind und so dem einströmenden Kühlmedium zugewandte weitere Eintrittsspalte (5, 6) für das gasförmige Medium bilden,
- wenigstens eine Heizvorrichtung (7), durch die wenigstens ein Ansaugfilter zumindest teilweise beheizbar ist, wobei die Heizvorrichtung wenigstens ein Heizelement (7) umfaßt, das zumindest teilweise innerhalb wenigstens eines Einströmprofils (1) angeordnet ist, **gekennzeichnet durch**
- wenigstens einen Strömungswächter, **durch** den die Strömung des gasförmigen Kühlmediums erfaßbar ist, und
- wenigstens eine Schalteinrichtung, **durch** die die Heizvorrichtung (7) bei fehlender Strömung zuschaltbar und bei wiedereintretender Strömung abschaltbar ist.

2. Filtereinrichtung nach Anspruch 1, **dadurch gekennzeichnet, daß** die Einströmprofile (1) und/oder Abscheideprofile (3, 4) als Hohlkörper ausgeführt sind, deren Querschnitte sich in Srömungsrichtung verjüngen, wobei die sich verjüngenden Abschnitte ebenfalls als Hohlprofile ausgeführt sind, und wobei in und/oder an dem sich verjüngenden Abschnitt wenigstens eines der Hohlprofilabschnitte das Heizelement angeordnet ist.

3. Filtereinrichtung nach Anspruch 2, **dadurch gekennzeichnet, daß** der sich verjüngende Abschnitt (151, 191, 211) eine separate, geschlossene oder offene Hohlkammer (16, 20, 22) bildet, in welchem das Heizelement () angeordnet ist.

4. Filtereinrichtung nach Anspruch 3, **dadurch gekennzeichnet, daß** die Hohlkammer (22) im Querschnitt kreisförmig ausgebildet ist.

5. Filtereinrichtung nach Anspruch 3, daß die Hohlkammer (20) im Querschnitt dreieckförmig ausgebildet ist.

6. Filtereinrichtung nach einem der Ansprüche 1 bis 5, **dadurch gekennzeichnet, daß** die Querschnitte von Hohlkammer (16, 20, 22) und Heizelement (17) so gestaltet sind, daß das Heizelement mit Formschluß in der Hohlkammer zu haltern ist.

7. Filtereinrichtung nach einem der Ansprüche.1 bis 6, **dadurch gekennzeichnet, daß** das Heizelement (17) aus ein oder mehreren, von einem Trägermaterial umgebenden Heizdrähten (18) besteht.

8. Filtereinrichtung nach Anspruch 7, **dadurch gekennzeichnet, daß** das Trägermaterial so ausgebildet ist, daß es formschlüssig an die Außen- bzw. Innenkontur der Profile angepasst ist.

9. Filtereinrichtung nach Anspruch 7, **dadurch gekennzeichnet, daß** als Trägermaterial ein in die Hohlkammer einbringbarer Isolierstab oder eine in die Hohlkammer einbringbare Schüttung aus Isoliermaterial vorgesehen ist.

10. Filtereinrichtung nach einem der Ansprüche 1 bis 9,
**dadurch gekennzeichnet, daß** bei einer Anordung ,
bei der das Ansaugfilter mehrere voneinander beabstandete Einstömprofile (1) und Abscheideprofile (3, 4, 15, 19, 21, 23, 25, 28) aufweist, von denen jeweils zwei benachbarte Einströmprofile jeweils einen Gitter-Eintrittsspalt (2) für das gasförmige Medium bilden, und bei der die Abscheideprofile parallel zu den Einströmprofilen verlaufen und in Strömungsrichtung gesehen, hinter den Einströmprofilen angeordnet sind, Heizelemente (7, 17, 24, 26) sowohl bei zumindest einigen Einströmprofilen als auch bei zumindest einigen unmittelbar dahinter liegenden Abscheideprofilen vorhanden sind.

11. Filtereinrichtung nach einem der Ansprüche 1 bis 10, **dadurch gekennzeichnet, daß** die Abscheideprofile (3, 4) teilweise als Grobabscheideprofile (3) und teilweise als Feinabscheideprofile (4) ausgebildet sind, wobei die Feinabscheideprofile (4), in Strömungsrichtung gesehen, hinter den Grobabscheideprofilen (3) angeordnet sind.

12. Filtereinrichtung nach Anspruch 1, **dadurch gekennzeichnet, daß** das Heizelement als mehrfach U-förmig gebogener Heizstab (7) mit einem vorzugsweise kreisförmigen Querschnitt ausgebildet ist.

13. Filtereinrichtung nach Anspruch 1, **dadurch gekennzeichnet, daß** zumindest ein Einströmprofil (1) und/oder ein Abscheideprofil (3, 4) selbst als Heizelement ausgebildet ist.

14. Filtereinrichtung nach Anspruch 1, **dadurch gekennzeichnet, daß** das Ansaugfilter als Feinstaubfilter ausgebildet ist und die Heizvorrichtung mehrere Heizfäden (10) umfaßt, die im Inneren des Feinstaubfilters und/oder auf wenigstens einer der beiden Stirnflächen (11, 12) des Feinstaubfilters angeordnet sind.

## Claims

1. Filtering device which comprises the following features:
- at least one suction filter through which a gaseous cooling medium can flow and which has a number of inflow profiles (1) and separating profiles (3, 4) which are spaced apart from one another, two adjoining inflow profiles (1) in each case forming a grid entrance slit (2) for the gaseous medium, and the separating profiles (3, 4) extending parallel to the inflow profiles (1) and being arranged behind the latter, viewed in the direction of flow, and thus forming additional entrance slits (5, 6) for the gaseous medium which face towards the said cooling medium flowing in;
- at least one heating apparatus (7) by which at least one suction filter can be heated, at least partially, the said heating apparatus comprising at least one heating element (7) which is arranged, at least partially, inside at least one inflow profile (1), **characterised by**
- at least one flow-monitor by which the flow of the gaseous cooling medium can be detected, and
- at least one switching device by which the heating apparatus (7) can be switched on when the flow fails and switched off when the said flow sets in again.

2. Filtering device according to claim 1, **characterised in that** the inflow profiles (1) and/or separating profiles (3, 4) are constructed as hollow bodies whose cross-sections taper in the direction of flow, the tapering sections likewise being constructed as hollow profiles, and the heating element being arranged in and/or on the tapering section of at least one of the hollow-profile sections.

3. Filtering device according to claim 2, **characterised in that** the tapering section (151, 191, 211) forms a separate, closed or open hollow chamber (16, 20, 22) in which the heating element () is arranged.

4. Filtering device according to claim 3, **characterised in that** the hollow chamber (22) is of circular design in cross-section.

5. Filtering device according to claim 3, **characterised in that** the hollow chamber (20) is of triangular design in cross-section.

6. Filtering device according to one of claims 1 to 5, **characterised in that** the cross-sections of the hollow . chamber (16, 20, 22) and the heating element (17) are configured in such a way that the heating element can be held in the hollow chamber by form-locking.

7. Filtering device according to one of claims 1 to 6, **characterised in that** the heating element (17) consists of one or more heating wires (18) surrounded by a carrier material.

8. Filtering device according to claim 7, **characterised in that** the carrier material is designed in such a way that it is adapted to the outer or inner contour of the profiles in a form-locking manner.

9. Filtering device according to claim 7, **characterised in that** an insulating bar which can be introduced into the hollow chamber, or a filling of insulating material which can be introduced into the said hollow chamber, is provided as the carrier material.

10. Filtering device according to one of claims 1 to 9, **characterised in that,** in an arrangement in which the suction filter has a number of inflow profiles (1) and separating profiles (3, 4, 15, 19, 21, 23, 25, 28) which are spaced apart from one another and of which two adjoining inflow profiles in each case form a grid entrance slit (2) for the gaseous medium, and in which arrangement the separating profiles extend parallel to the inflow profiles and are arranged behind the latter, viewed in the direction of flow, heating elements (7, 17, 24, 26) are present, both in the case of at least some of the inflow profiles and also in the case of at least some of the separating profiles located immediately behind them.

11. Filtering device according to one of claims 1 to 10, **characterised in that** the separating profiles (3, 4) are designed, in some cases, as coarse separating profiles (3) and, in some cases, as fine separating profiles (4), the said fine separating profiles (4) being arranged behind the coarse separating profiles (3), viewed in the direction of flow.

12. Filtering device according to claim 1, **characterised in that** the heating element is designed as a heating bar (7) which is bent a number of times in a U-shaped manner and has a preferably circular cross-section.

13. Filtering device according to claim 1, **characterised in that** at least one inflow profile (1) and/or one separating profile (3, 4) is itself designed as a heating element.

14. Filtering device according to claim 1, **characterised in that** the suction filter is designed as a fine-dust filter and the heating device comprises a number of heating filaments (10) which are arranged in the interior of the said fine-dust filter and/or on at least one of the two end faces (11, 12) of the latter.

## Revendications

1. Installation de filtration qui comporte les caractéristiques suivantes :
- au moins un filtre d'aspiration à travers lequel peut passer du fluide gazeux de refroidissement, le filtre d'aspiration ayant plusieurs profilés (1) d'affluence et profilés (3, 4) de séparation à distance les uns des autres, deux profilés (1) d'affluence voisins formant respectivement une fente (2) d'entrée à grille pour le fluide gazeux, et les profilés (3, 4) de séparation s'étendant parallèlement aux profilés (1) d'affluence et étant disposés, considéré dans le sens du courant, en aval des profilés (1) d'affluence et formant ainsi d'autres fentes (5, 6) d'entrée du fluide gazeux tournées vers le fluide de refroidissement affluent,
- au moins un dispositif (7) de chauffage, par lequel le au moins un filtre d'aspiration peut être chauffé au moins en partie, le dispositif de chauffage comprenant au moins un élément (7) de chauffage qui est disposé au moins en partie à l'intérieur d'au moins un profilé (1) d'affluence, **caractérisé par**
- au moins un dispositif de surveillance du courant, par lequel le courant du fluide gazeux de refroidissement peut être détecté, et
- au moins un dispositif interrupteur, par lequel le dispositif (7) de chauffage peut être mis en circuit s'il n'y a pas de courant et peut être mis hors circuit lorsque le courant revient.

2. Dispositif de filtration suivant la revendication 1, **caractérisé en ce que** les profilés (1) d'affluence et/ou les profilés (3, 4) de séparation sont réalisés sous la forme de pièces creuses dont les sections transversales se rétrécissent dans le sens de l'écoulement, les tronçons se rétrécissant étant également réalisés sous la forme de profilés creux, et l'élément de chauffage est monté dans et/ou sur le tronçon se rétrécissant d'au moins l'un des profilés creux.

3. Dispositif de filtration suivant la revendication 2, **caractérisé en ce que** le tronçon (151, 191, 211) se rétrécissant forme une chambre (16, 20, 22) creuse distincte, fermée ou ouverte, dans laquelle est disposé l'élément (17) de chauffage.

4. Dispositif de filtration suivant la revendication 3, **caractérisé en ce que** la chambre (22) creuse a une section transversale de forme circulaire.

5. Dispositif de filtration suivant la revendication 3, **caractérisé en ce que** la chambre (20) creuse a une section transversale triangulaire.

6. Dispositif de filtration suivant l'une des revendications 1 à 5, **caractérisé en ce que** les sections transversales de la chambre (16, 20, 22) creuse et de l'élément (17) de chauffage sont conformées de manière à ce que l'élément de chauffage soit maintenu par complémentarité de forme dans la chambre creuse.

7. Dispositif de filtration suivant l'une des revendications 1 à 6, **caractérisé en ce que** l'élément (17) de chauffage est constitué d'un fil (18) ou de plusieurs fils (18) de chauffage entouré(s) d'un matériau support.

8. Dispositif de filtration suivant la revendication 7, **caractérisé en ce que** le matériau support est tel qu'il s'adapte par complémentarité de forme au contour extérieur ou intérieur des profilés.

9. Dispositif de filtration suivant la revendication 7, **caractérisé en ce qu'**il est prévu, comme matériau support, un barreau isolant pouvant être introduit dans la chambre creuse ou un tas de matériau isolant pouvant être introduit dans la chambre creuse.

10. Dispositif de filtration suivant l'une des revendications 1 à 9, **caractérisé en ce que**, pour un agencement dans lequel le filtre d'aspiration a plusieurs profilés (1) d'affluence et profilés (3, 4, 15, 19, 21, 23, 25, 28) de séparation à distance les uns des autres, dont respectivement deux profilés d'affluence voisins forment respectivement une fente (2) d'entrée de grille pour le fluide gazeux et dans lequel les profilés de séparation s'étendent parallèlement aux profilés d'affluence et sont disposés, considéré dans le sens du courant, en aval des profilés d'affluence, il y a des éléments (7, 17, 24, 26) de chauffage tant pour au moins quelques profilés d'affluence que pour au moins quelques profilés de séparation se trouvant immédiatement derrière.

11. Dispositif de filtration suivant l'une des revendications 1 à 10, **caractérisé en ce que** les profilés (3, 4) de séparation sont constitués en partie sous la forme de profilés (3) de séparation grossiers et en partie sous la forme de profilés (4) de séparation fins, les profilés (4) de séparation fins étant disposés, considéré dans le sens du courant, en aval des profilés (3) de séparation grossiers.

12. Dispositif de filtration suivant la revendication 1, **caractérisé en ce que** l'élément de chauffage est constitué sous la forme d'un barreau (7) de chauffage recourbé plusieurs fois en forme de U et ayant une section transversale de préférence circulaire.

13. Dispositif de filtration suivant la revendication 1, **caractérisé en ce qu'**au moins un profilé (1) d'affluence et/ou un profilé (3, 4) de séparation est constitué soi-même en élément de chauffage.

14. Dispositif de filtration suivant la revendication 1, **caractérisé en ce que** le filtre d'aspiration est constitué sous la forme d'un filtre pour de la poussière fine et le dispositif de chauffage comprend plusieurs filaments (10) de chauffage qui sont disposés à l'intérieur du filtre pour de la poussière fine et/ou sur au moins l'une des deux surfaces (11, 12) frontales du filtre pour de la poussière fine.
